# EUROPEAN PATENT SPECIFICATION

(11) **EP 2 212 906 B1**
(45) Date of publication and mention of the grant of the patent: **16.02.2022**
(21) Application number: 08842674.7
(22) Date of filing: 27.10.2008
(51) Int. Cl.: B08B 3/10, B08B 3/00, H01L 21/302, H01L 21/304, H01L 21/02, H01L 21/67

(54) **CYCLIC NUCLEATION PROCESS**
ZYKLISCHER NUKLEIERUNGSPROZESS
PROCÉDÉ DE NUCLÉATION CYCLIQUE

(30) Priority: 27.10.2007 US 983158 P
(43) Date of publication of application: 04.08.2010
(73) Proprietor: LPW Reinigungssysteme GmbH, 72585 Riederich (DE)
(72) Inventor: GRAY, Donald, Temple AZ 85282 (US); PLAVIDAL, Rick, Fremont CA 94536 (US); FREDERICK, Charlottle, Tempe AZ 85282 (US)
(74) Representative: Patentanwälte und Rechtsanwalt Weiß, Arat & Partner mbB
(86) International application number: PCT/US2008/081397
(87) International publication number: WO 2009/055834

(56) References cited:
- JP-A- 5 160 097
- JP-A- 6 252 115
- JP-A- 2001 246 337
- JP-A- 2005 166 906
- US-A- 5 868 898
- US-B1- 6 418 942

## Description

This application claims priority from U.S. provisional patent application serial no. 60/983,158, filed on 10/27/2007, entitled "Cyclic Nucleation Process.

### Background

Semiconductor cleaning is an important process for preparing integrated circuits with high yields. Traditionally, the standard cleaning method often involves one or more forms of an RCA cleaning procedure. The RCA clean processes typically use a mixture of hydrogen peroxide and ammonium hydroxide or hydrochloric acid to remove particulates and contaminants.

In nano-processes, the particles or contaminants might be in high aspect ratio nano-trenches or vias, and thus are difficult to be cleaned efficiently due to the limit of the liquid surface boundary layer. Cleaning process improvements include ultrasonic or megasonic-assisted cavitation processes in a liquid medium. Typically, ultrasonic sound waves are used to produce randomly tiny collapsing bubbles near the solid surface. The energy of the ultrasonic waves is released into the fluid and the heat created by this energy evaporates small volumes of the fluid at the surface of the object, forming vapor bubbles. The vapor bubbles are cooled by the surrounding fluid and collapse, releasing their energy into the bulk fluid on implosion. The strength and aggressiveness of the imploding energy can be controlled by controlling the frequency and wavelength of the ultrasonic waves. Low frequency, long wavelength ultrasound produces smaller, less aggressive vapor bubbles that are usually used to cover more surface area and be less erosive to the material being cleaned.

### Summary

The present invention discloses a surface treatment using a cyclic nucleation process (CNP). According to the present invention, optimum conditionsin cyclic applications, for the production and collapse/detach/implode of vapor bubbles on a solid surface are provided to produce an energy release directly on the solid surface. The process is accomplished by alternating chemical, in addition to vacuum/pressure to produce a pulsing action within a fluid.

In exemplary embodiments, the present invention is directed to the formation of vapor bubbles at the surface of an object such as a part or a wafer, which is at least partially submerged in a cleaning liquid. In this process, bubbles begin to nucleate along the object surface when the conditions in the cleaning chamber reach the vapor pressures of the volatile solvents in the cleaning liquid. The termination of these bubbles, such as collapsing, detaching or imploding, acts to gently remove small particles and contamination from the object surface. The generation and termination of cleaning bubbles can be cycled up and down repeatedly to produce a very effective, yet gentle, cleaning action.

It is disclosed herein a method for treating an object, comprising alternating pressure and vacuum within the process chamber to cause decompression bubbles to form and terminate at a submerged surface of the object. . After the object is at least partially submerged in a cleaning liquid, the temperature of the object can be cycled, e.g. increasing and decreasing, preferably until a desired result, such as a proper cleaning process, is achieved. In an aspect, the temperature is increased until the cleaning liquid in the vicinity of the object surface reaches vapor pressure conditions for nucleating bubbles along the object surface. For example, at boiling temperature, the bubbles can rapidly form and boil off. In an aspect, the temperature is increased to a temperature less than the boiling temperature. In an aspect, after the bubbles are formed at the object surface, the temperature of the object is decreased to terminate the bubbles. The termination of the bubbles can generate energy to remove any particles adhering to the object.

After introducing a cleaning liquid to submerge at least a portion of the object, the object is heated to cause bubbles to form at the submerged surface. The heating is then reduced to terminate the bubbles, transferring energy to the surface of the object for treating the object surface. The heating and reducing heating process can be repeated until a desired treatment is accomplished.

It is disclosed herein an example, wherein the cycling of temperature or heating/cooling the object is further enhanced by cycling the pressure and vacuum of the environment surrounding the object. In an aspect, the object is positioned in a process chamber, and the pressure Within the process chamber increases and decreases cyclically to promote the generation and termination of the bubbles.

The present invention discloses a method for treating an object, comprising flowing a chemical active liquid or agent to promote bubble generation at the object surface. For example, the chemical active agent can be a peroxide or an acid. The flow of chemical active agent can be stopped to promote the termination of bubbles for surface treatment. Alternatively, another liquid can be flowed without stopping the chemical active agent to terminate the bubbles or terminate the generation of bubbles. In an aspect, the object can be partially submerged in a cleaning liquid, or a cleaning liquid can be flowed onto the object to submerge at least a portion of the object. The chemical active agent can be cyclically injected into the cleaning liquid to form and terminate the bubbles.

In an embodiment, the treating using cyclic pressure can be combined with temperature or heating as per the above examples to promote generation and termination of cleaning bubbles, imparting energy to the object surface for an effective treatment. The combination of these processes is preferably designed to enhance the generation and termination of the bubbles. For example, a vacuum condition, a heating condition, a high temperature condition, and chemical active agent condition can promote bubble formation, and thus can be combined to enhance the generation of bubbles. Cleaning liquid flow can be employed for removing particles, and can also act to cool the object during the reducing heating phase, or during the removal of chemical active agent.

### Brief description of the drawings

Fig. 1 illustrates a single wafer chamber designed for examples of the present cyclic nucleation process.
Fig. 2 illustrates another exemplary process chamber using a showerhead for introducing the fluid.
Fig. 3 illustrates a rotating chamber roof example where the chamber roof can be rotated, together with a rotating substrate.
Fig. 4 illustrates another exemplary single wafer cyclic nucleation cleaning chamber.
Fig. 5 illustrates a process for treating an object employing the present cyclic nucleation process with thermal cycle nucleation. The process shown in Figure 5 is not part of the present invention.
Fig. 6 illustrates another process for treating an object with thermal cycle nucleation. The process shown in Figure 6 is not part of the present invention.
Fig. 7 illustrates an exemplary embodiment for treating the object employing both pressure and temperature/heating cycling. The process shown in Figure 7 is not part of the present invention.
Fig. 8 illustrates an embodiment for treating an object with the present cyclic nucleation process employing chemical cycle nucleation.
Fig. 9 illustrates another embodiment for treating an object with the present cyclic nucleation process employing chemical cycle nucleation.
Fig. 10 illustrates an exemplary embodiment of the present invention.

### Detailed Description

The concept of using bubbles in a liquid to aid cleaning has been around since the invention of soap. In the world of semiconductor wafer processing, the role of bubbles (aka nucleation of gas vapor inside a liquid) is growing in importance. As device geometries shrink, there is a corresponding reduction in the minimum size of killer defect particles - those particles which are physically large enough to damage or destroy semiconductor device performance. Conventional methods of particle removal on silicon wafers have required the physical breakdown of liquid boundary layers by applying external energy-such as ultrasonic energy. As killer defect particle sizes have shrunk over the years, more and more external energy has been applied to reduce the thickness of the boundary layer. The fundamental problem is that the energy required to remove these small particles has increased to the point that it also damages delicate wafer structures and may thereby destroy devices. Vapor bubbles can be an effective means of altering this trend since their physical and chemical cleaning attributes are proving beneficial for advanced semiconductor cleaning processes as well as other advanced cleaning applications.

Within the micro region of a growing bubble, three physical particle removal mechanisms are taking place. The growing edge of the bubble actually acts as a forced convection removal process for particles. The rapid transition of this interface, from expanding during bubble growth to rapid fluid flushing during bubble detachment, produces fluid impingement action on the surface. Since the bubble grows at the surface, any particle on the surface sees fluid motion and can be physically detached.

A second mechanism is related to the surface-active forces at the growing bubble vapor-solid interface. As in most cleaning processes, surface-active agents that would be concentrated in this region have been shown to enhance the removal process. Bubble formations expose particles to compatible chemistries that can attach and remove the particles similar to floatation processes used to clarify water.

A third particle removal mechanism is the fluid evaporation within this region. The leading edge of the growing bubble is the main latent heat transfer area since the film thickness in this area is very small. The effect is similar to rapid laser evaporation of fluids that has been shown to be a successful particle removal process for semiconductors.

In exemplary embodiments, the present invention discloses a surface treatment with bubbles, employing the imparting of energy resulted from the termination of bubbles to treat an object surface. The bubbles are generally formed at the surface of the object, e. g., a part or a wafer, exposed to a cleaning liquid, in response to an input. In an embodiment, the present invention allows cleaning particles from surface out into the bulk fluid or other media. In other words, the present process "locate and disrupt/disturb" the particle/contaminates directly at its interface to the solid surface by various means such as temperature, pressure, chemicals, or any combination thereof. In this process, bubbles begin to nucleate along the wafer surface when the conditions in the cleaning chamber reach the vapor pressure(s) of the volatile solvents in the cleaning liquid. These bubbles act to gently remove small particles and contamination from the wafer surface. The conditions inside the process chamber can be cycled up and down repeatedly to produce a very effective, yet gentle, cleaning action. The present nucleation technology can provide key attributes that are beneficial to advanced semiconductor and other advanced cleaning applications:
1. Gentle: Since the bubble nucleation site started at the wafer surface, there is no need for the application of potentially damaging energy to break through the liquid boundary layer that forms along the surface of the wafer. Instead the bubble grows steadily until its size either causes it to separate from the surface or the thermal heat transfer reaches a balance where the latent heat of vaporization is offset by the increased thermal conductivity through the bubble's surface area. In either case, the bubble does not generate the damaging energy required by conventional cleaning technologies.
2. Physical selectivity: Nucleation sites always prefer discontinuities to aid bubble formation - whether this discontinuity is a liquid-solid boundary, a surface topographical feature, or a contamination particle. This natural preference aids the effectiveness of this technology. It is readily observable to anyone who examines the bubble formation along the sides of a drinking glass containing a freshly poured carbonated beverage.
3. Chemical selectivity: The chemistry of the gas vapor inside a bubble will be orders of magnitude more concentrated with the higher vapor pressure solvents in the cleaning liquid. With proper selection of cleaning liquid chemistries, this concentration of chemical vapors can be designed to attack and destroy specific particulate types. However, because these strong chemical reactants remain at relatively dilute levels in the cleaning liquid they may result in little damage to the wafer itself.
4. Topographical selectivity: Most cleaning mechanisms are most effective on planar surfaces where the particles are exposed above the flat surface of the wafer.

During the manufacture of real device wafers however, there is rarely a planar surface presented. Usually the killer defect type particles are the ones trapped against sidewalls and inside trenches and holes. These are nearly impossible to remove by conventional means. The present cyclic nucleation process (CNP) actually becomes more effective as wafer topography becomes more complex. The mechanism of this increased effectiveness is readily observable to anyone trying to boil water at the bottom of a test tube.

The shrinkage of semiconductor feature sizes to 50nm and below introduces new particle removal challenges as the attractive forces that cause nanometer-sized particles to adhere to wafer surfaces become much more intense. This increased sticking force occurs at the same time that device features grow ever smaller and more delicate. The demonstrated benefits of CNP technology have led to the exploration of additional methods for creating, removing and/or collapsing bubbles in a repetitive process sequence to extend and enhance this technology.

An implementation of the technology using vacuum and pressure to generate and implode bubbles was disclosed in US. Patents US. 6,418,942; 6,743,300; 6,783,602 B2; 6,783, 601B2; 6,824,620 B2; and 2007/0107748, known as VCN (vacuum cycle nucleation) or in some technical literature also referred to as VCS (vacuum cavitational streaming).

The present invention is directed to the use of active chemical agents, and optionally alternating temperature in addition to alternating pressure. Thus in preferred embodiments of the present invention, the increase of temperature, the introduction of active chemical agents, or the application of vacuum can form and grow vapor bubbles on the solid surface at nucleation sites, which then are collapsed (or detached or imploded) when temperature decreases, chemical agent flow reduces or pressure is reapplied, respectively. The level of temperature, active chemical agents, and pressure, and their rates can control the rate of growth and size of the bubbles, and the total energy released.

Unlike ultrasonic or megasonic-assisted processes, it would be expected that the size of the bubbles produced with the present processing can be much greater than that produced by ultrasound. The vapor bubbles can be selective to only nucleation sites and form bubbles directly on the solid surface as opposed to the uniform formation of the sonic bubble in the fluid that cover all surfaces. The size and bubble production rate should be similar to that produced in a boiling liquid, which is directly proportional to the rate of heat addition. Since boiling vapor bubbles form at surface crevices and imperfections, it would be expected that decompression bubbles should be very selective by nucleating at particles on the surface thus enhancing particle detachment from the surface, i.e. removal of the particles from the surface (cleaning). If the bubbles are collapsed at the surface, the effect should be like ultrasound in that the imploding bubble would release a large amount of localized energy. On the other hand, if the vapor bubble is allowed to detach from the surface, the particle would be exposed to a reforming boundary layer, and this action should enhance transfer of material to a surface as required in surface coating processes. Unlike ultrasound bubbles which are micron-level in size, and generally smaller than the particles being removed, vapor bubbles formed by the cyclic process would be larger and produce reforming viscous surface layers which can then have an effect on the particles.

These larger bubbles formed during the cyclic process are more selective than ultrasound bubbles by forming at the particle sites, and it is expected that this could produce a targeted energy directed on the solid surface unlike ultrasound waves which release energy directly to the fluid. For sensitive surfaces, or surfaces with crevice particles, decompression indeed provides a more selective, less destructive means for particle removal. In addition, pressure/temperature/chemical effects of the cyclic process are omnidirectional throughout the fluid and thus are not shielded from any areas of the solid surfaces. In contrast, ultrasound waves are directional and thus certain surfaces of the solid may be shielded from their effects. Furthermore, since pressure, temperature, or chemical equalizes in all directions, nucleating bubbles can be formed inside tubes just as easy as outside a tube.

In exemplary embodiments, the present invention is directed to fluid or any combination thereof with pressure cycling. Temperature and chemical cycling can have certain advantages, exemplified by rapid cycling and applying solvent mixture of varying concentration to selective treat nucleation sites on surfaces. The present invention is further directed to process chamber configurations to enable cycling temperature and multiple chemical fluid/vapor cycling and alternating of chemical mixtures. In exemplary embodiments, the present invention discloses the cyclic temperature conditions and alternating chemical mixtures necessary for nucleating, growing, detaching and collapsing vapor bubbles for advanced cleaning, film removal, and surface treatment applications. These applications include, but are not restricted to, semiconductor wafer processing, MEMS device processing, precision optics cleaning, electronics cleaning, medical device cleaning, medical device sterilization, and oil or lubricant removal.

In an embodiment not forming part of the present invention, it is disclosed to use thermal cycling (heating and cooling cycles) to create, grow and collapse vapor bubbles that will form when the pressure and temperature conditions are such that one or more liquid solvents reaches its boiling point in the solution. This specific process is named Thermal Cycle Nucleation (TCN), which is a subset of the cyclic nucleation process (CNP). The combination of TCN's temperature peaks and the naturally stronger chemical vapor concentrations inside vapor bubbles can be used to increase chemical reaction rates for improved particle removal efficiency. Further, thermal cycles (TCN) can be combined with vacuum cycles (VCN) for enhanced or varied effects. The present thermal cycling can enhance the basic nucleation-forming technology, and under certain conditions and applications the cycling speed of TCN may be as much as 10 times faster than for VCN.

The key benefits of using TCN either separately or in conjunction with VCN technology can include: more rapid cycling for greater throughput and higher particle removal efficiency; higher temperature peaks for more physically and aggressive cleaning action while maintaining a lower overall average temperatures to preserve wafer device integrity; no moving parts are necessary to cycle temperature whereas vacuum pressure cycling requires mechanical control which may generate particles; no emissions to the environment and provision of a completely closed loop; requiring little energy; can be adopted for flammable solvents since it can be inherently safe for operators and the environment; and instantaneously treating the entire surface without the need to mechanically concentrate heat methodically across the surface.

The following describes basic apparatus design and methodologies proposed to enable the implementation of Thermal Cycle Nucleation. These descriptions are included for explanation of how the TCN process can be practically implemented, but they are not intended to cover the full extent of possibilities for successful implementation of TCN, CNP, VCN and any combinations thereof.

CNP can consist of a large vacuum chamber where the part to be cleaned would be submerged in a bath of cleaning liquid. Temperature would be controlled and the vacuum level was cycled to repeatedly create and collapse vapor bubbles. A single wafer chamber can be used to offer smaller volume and thermal mass. The smaller process chamber would contain a single wafer exposed to a constant flow of fresh cleaning liquid (hence the shower vs. bath concept). In this kind of configuration, the constant flow of fresh liquid combined with the relatively small thermal mass of the wafer would facilitate rapid cooling once a heat source was removed from the wafer.

In a vacuum environment, radiant heat transfer can be preferable over conductive and convective heat transfer mechanisms. A good solution is to use radiant lamp heat as it has the capability to instantly heat the wafer and also will immediately stop heating the wafer the moment the lamps are turned off. Since the temperature range for cycling can be relatively small, in the order tens of degrees to less than a few hundreds of degrees, the cycle time for heating can be quite short, even tenths of a second. It should be noted that radiant lamp heating has been used in rapid annealing processes for semiconductor wafer processing. These processes are referred to as RTP (Rapid Thermal Processing) and it has demonstrated the capability to heat wafers to over 1000 degrees in a few seconds. For TCN temperature ranges the heating cycle can be even shorter. This rapid cycling rate enables many TCN cycles to be performed on each wafer to maximize wafer throughput and achieve high particle removal efficiency.

The wafer may be rotated for increased convective cooling flow and bubble/particle displacement from the wafer surface as a result of centrifugal forces. The rotating wafer will cause cleaning liquid, which is introduced in a stream directed at the center of the wafer, to flow out in a radial manner. The actual flow dynamics can be controlled both by varying the wafer's rotational speed as well as controlling the flow conditions of the cleaning liquid. An increased flow combined with higher rotational velocities will increase flow rates, reduce boundary layer thickness, and increase both convective and conductive heat transfer.

A rotating chamber roof can be used to centrifugally remove condensates from the relatively cooler chamber walls without allowing drops to fall back on the wafer surface. Keeping particles from re-depositing on the wafer surface can be a key concern in certain embodiments. As the bubbling processes associated with nucleation cycling techniques can cause some spattering as well as condensation on chamber walls, adding a rotating chamber roof above the wafer will sufficiently capture and transport these deposits safely away from the wafer. This technique allows for a sufficiently narrow gap between the wafer and chamber roof which allows for a smaller overall chamber volume. A smaller chamber volume facilitates more rapid temperature and pressure control among other potential benefits.

A variation on this theme is to have a rotating chamber roof that is somewhat flexible and can be lowered almost to the wafer surface, with only the cleaning fluid separating the two parts. In this way there is no surface that can accumulate potential contamination.

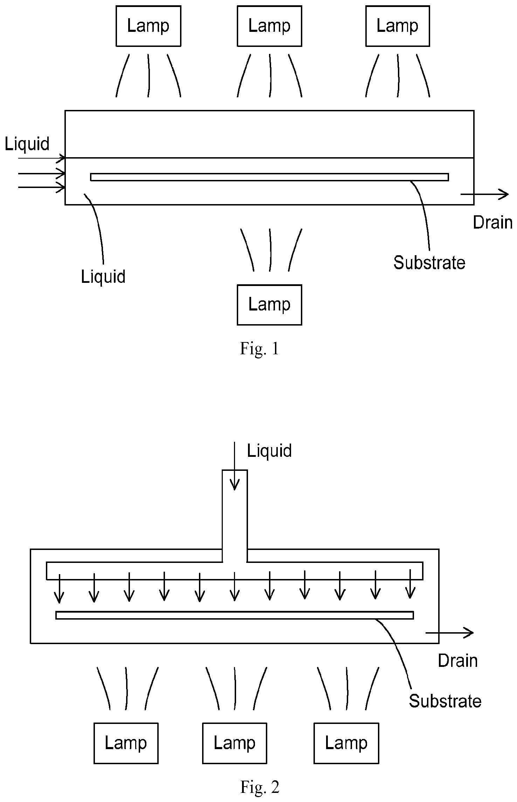

Fig. 1 illustrates a single wafer chamber designed for examples of the present cyclic nucleation process. The substrate is submerged within the chamber with liquid entering from the side, and drained from another side. A plurality of heat lamps are installed for heating the substrate. Other configurations can also be implemented, for example, the heat lamps are installed in only one side, the heat lamp can be replaced with a resistive heating such as a heat chuck, the liquid can enter from the top, the substrate can touch the bottom wall of the chamber, the liquid can flow through the substrate without submerging the substrate, or the substrate can be rotated.

Fig. 2 illustrates another exemplary process chamber using a showerhead for introducing the fluid. Additionally, the liquid can enter from a side, and the substrate can be submerged.

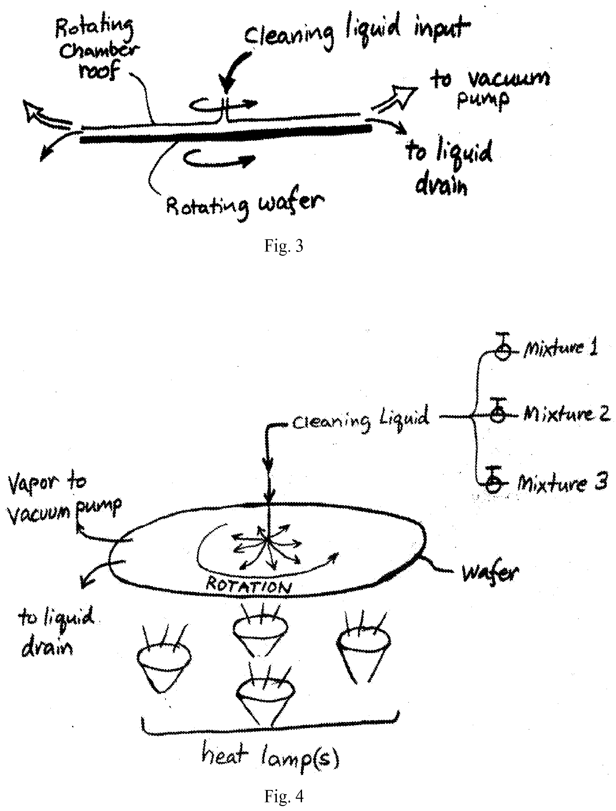

Fig. 3 illustrates a rotating chamber roof example where the chamber roof can be rotated, together with a rotating substrate. The cleaning liquid can enter from the top of the rotating roof, and exhausts to the liquid drain through centrifugal force. Vacuum pump can remove gas and vapor from the chamber.

Fig. 4 illustrates another exemplary single wafer cyclic nucleation cleaning chamber. Various mixtures of cleaning fluid can be jetted, sprayed or flowed onto a rotating substrate. Due to the centrifugal force, the fluid is exhausted to a liquid drain, and the vapor can be pumped out with a vacuum pump. Heat lamps can be used to change the temperature of the substrate or the fluid.

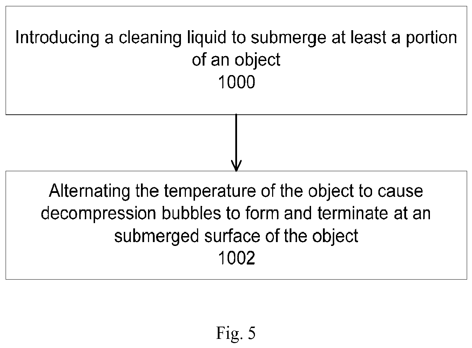

Fig. 5 illustrates a process for treating an object employing the cyclic nucleation process with thermal cycle nucleation. Operation 1000 introduces a cleaning liquid to submerge at least a portion of the object. The liquid can be introduced through a showerhead, or an injection port such as a center injection inlet. The cleaning liquid can be a solvent. The cleaning liquid can be introduced with a vapor phase for equalizing the pressure before proceeding with a liquid phase. Operation 1002 alternates the temperature of the object to cause decompression bubbles to form and terminate at a submerged surface of the object. In an aspect, the decompression bubbles treat the object in a desirable manner, such as cleaning the surface, by generating energy from the termination of the bubbles. The termination of the bubbles can comprise collapsing, detaching, or imploding the bubbles. The alternation of object temperature can cause the decompression bubbles to cyclically form and terminate on a surface of the object. The alternation of temperature can be accompanied by an alternation of pressure and chemical active liquid flow to aid in the forming and terminating of the bubbles.

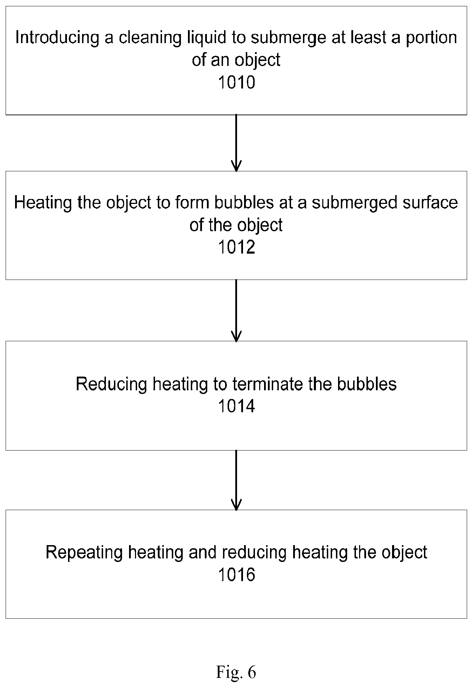

Fig. 6 illustrates another example process for treating an object with thermal cycle nucleation. Operation 1010 introduces a cleaning liquid to submerge at least a portion of the object. Operation 1012 supplies thermal energy to the object to heat the object to form bubbles at a submerged surface of the object. The heating of the object can heat the liquid at the vicinity of the object surface, causing bubbles to form. Operation 1014 reduces the thermal energy, or cools the object, to terminate the bubbles, providing energy to the object surface for treating the object. The cycle can be repeated in operation 1016 with heating/reducing heating (or heating and cooling) the object for forming and terminating the bubbles. The heating can be performed by lamp heating for fast cycling.

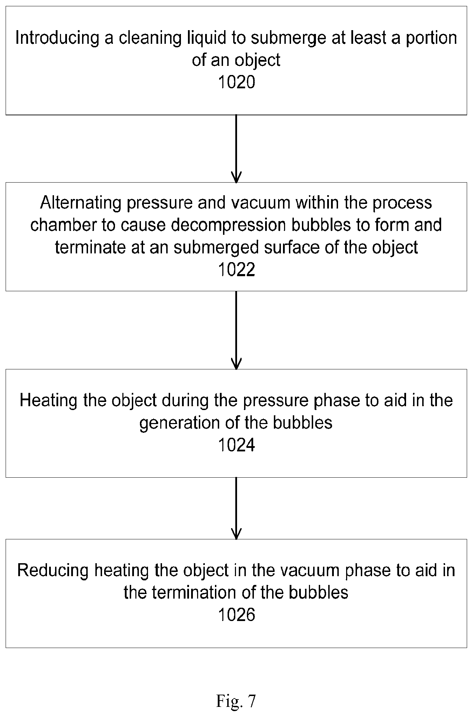

Fig. 7 illustrates an example for treating the object employing both pressure and temperature/heating cycling. Operation 1020 introduces a cleaning liquid to submerge at least a portion of the object in a process chamber. Operation 1022 alternates pressure and vacuum within the process chamber to cause decompression bubbles to form and terminate at a submerged surface of the object. The pressure values can oscillate between a high pressure and a low pressure values. The pressure can be atmospheric, sub-atmospheric, or above atmospheric levels. The vacuum levels can be sub-atmospheric, in the ranges of ten Torr, Torr, or sub-Torr pressure. Operation 1024 heats the object during the pressure phase to aid in the generation of bubbles. Operation 1026 reduces heating, or cools, the object to aid in the termination of the bubbles.

In an embodiment, the present invention applies in a cyclical manner, different chemical solutions/vapor to either create, grow vapor bubbles to treat the surface by collapse or implosion of vapor bubbles on the surfaces of an object. When applied in conjunction with pressure and thermal conditions, the process can selective grow vapor bubbles of one chemistry and implode or collapse with the stopping of the chemistry, or the introduction of a different vapor or liquid for treat of the first vapor or fluid. This can be followed by additional fluid or vapor for treatment of the additional cycles. This specific process is named Chemical Cycle Nucleation (CNP). In one aspect, varying concentrations fluid mixtures of chemical vapors/fluids can be applied in an alternating manner to either create or grow vapor bubbles to treat the surface by collapse or implode vapor bubbles on the surfaces of an object.

Processing with CNP can provide additional benefits, such as the treated surfaces remain wet during cycling vapors/fluids or alternating concentrations. Further, the cycling and alternating fluid concentration of different chemical vapors or liquids form chemical mixtures directly on surfaces that are compounded to inhibit or eliminate redeposition of particle and complex chemical formulation such as photoresist, adhesives, polymer coatings, electronic fluxes. Chemical mixtures can be tailored to promote rapid chemical dissolving and breakdown of the complex chemical bonding of the surface contaminates.

The present CNP process can enhance the basic nucleation-forming technology, and under certain conditions and applications the cycling different chemical vapors or liquid can inhibit or eliminate redeposition of particle and specific complex chemical formulation such as photoresist, adhesives, polymer coatings, electronic fluxes and promote breakdown of the chemical bonding structure to promote rapid dissolving or displacement of said contaminates.

The key benefits of using CNP either separately or in conjunction with VCN technology include: more rapid cycling for greater throughput, higher particle removal efficiency and removal of residues from tight offsets and vias; vapor to be superheated thus making for more physically and aggressive cleaning action by taking fully advantage of diffusion while maintaining a lower overall average temperatures to preserve wafer device integrity; substantial increase in diffusion power of a chemical dissolute in its vapor state than when in its liquid state; no emissions to the environment and is completely closed loop; requiring little energy; can be adopted for flammable solvents since it can be inherently safe for operators and the environment; cleaning surface can always be wet; rapid drying of surfaces; surfaces can be selective chemically treated only at the nucleation site of object surface utilizing varying chemical concentration and alternating or cycle chemical solvents, aqueous, acid, etch or mixture of different chemical concentrations at the nucleation site of the object only; enhancing the ability to match the appropriate chemical vapor/fluids for highest affectivity and efficiency of the contaminate specific to the nucleation site on the surfaces; and selective removal of a known chemically complex material by rapid dissolving and breaking down of chemical bonds with selected chemical dissolver and oxidizers at the nucleation site of the contaminate.

Sub micron particle removal from wafers will probably require 5 available mechanisms. Forced convection, bubble implosion, rapid evaporation, chemical adhesion and chemical etching may all be required.

The following describes basic apparatus design and methodologies proposed to enable the implementation of Chemical Cycle Nucleation. These descriptions are included for explanation of how the CNP process can be practically implemented, but they are not intended to cover the full extent of possibilities for successful implementation of TCN, CNP, VCN and any combinations thereof.

The new process can utilize the cycling of multiple fluids/vapors to treat surfaces of an object, using a vacuum chamber for a batch process or a single wafer process. An example of the new CNP process would be in the removal of Photo-Resist from Semiconductor Wafers: An enclosed solvent or aqueous chemical cycle nucleation (CNP) system includes a chamber for holding a wafer to be processed. At least one vacuum pump applies a negative gauge pressure to the chamber to remove air and other non-condensable gases. Means are provided for introducing a solvent to the evacuated chamber to submerge the wafer contained within. The solvent is comprised of organic medium used to dissolve the resist and an inorganic solution such as a peroxide or acid used to oxidize the carbon element of the resist. A first system removes pressure from the chamber to produce vapor bubbles for agitation and disruption of the boundary layer surrounding the resist and to vaporize the inorganic component for faster reaction in the vapor state. Upon recovering the solvent, a second solvent is introduced to the chamber and a second system removes pressure from the chamber to produce vapor bubbles for agitation and rinsing of the wafer. The system includes recovery of the solvent from the chamber and wafer.

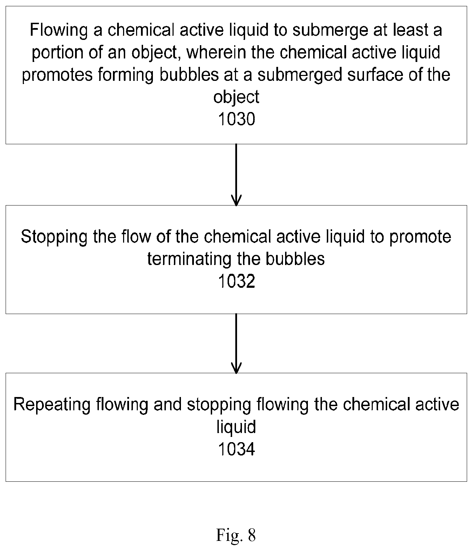

Fig. 8 illustrates an embodiment for treating an object with the present cyclic nucleation process employing chemical cycle nucleation. Operation 1030 flows a chemical active agent or liquid to submerge at least a portion of the object, wherein the chemical active liquid promotes forming bubbles at a submerged surface. The chemical active liquid can be an oxidizer, a liquid with high bubble formation, or a liquid with lower vapor pressure. Exemplary chemical active liquids include peroxide chemicals, alkalines, solvents or acids. Operation 1032 stops the flow of the chemical active liquid to promote terminating the bubbles, or to help slow down or speed up the generation of bubbles. The process is repeated in operation 1034 with the cyclic pulsing of the chemical active liquid. In an aspect, the chemical active liquid is pulsed to the process chamber where the object is positioned. In another aspect, the chemical active liquid is injected to a cleaning liquid to promote generating bubbles, retard growing bubbles, enhance diffusion or inhibit diffusion.

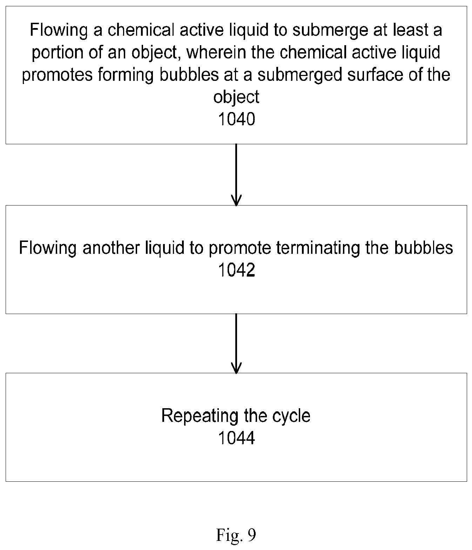

Fig. 9 illustrates another embodiment for treating an object with the present cyclic nucleation process employing chemical cycle nucleation. Operation 1040 flows a chemical active agent or liquid to submerge at least a portion of the object, wherein the chemical active liquid promotes forming bubbles at a submerged surface. Operation 1042 flows another liquid to promote terminating the bubbles. This other liquid can be a cleaning liquid, a solvent, or an actively bubble terminating liquid. Operation 1044 repeats the cycle until a desired result is achieved.

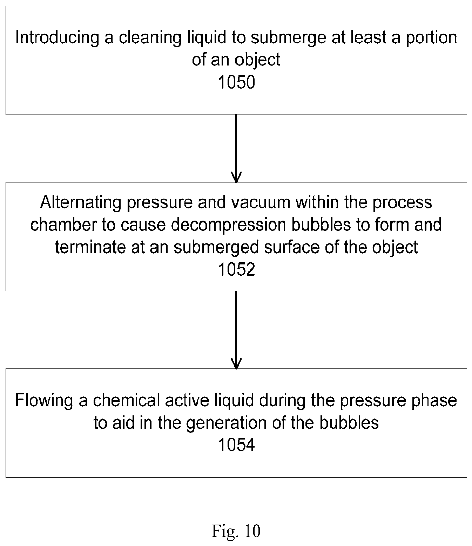

Fig. 10 illustrates an exemplary embodiment of the present invention. Operation 1050 introduces a cleaning liquid to submerge at least a portion of the object. Operation 1052 alternates pressure and vacuum within the process chamber to cause decompression bubbles to form and terminate at a submerged surface of the object. Operation 1054 flows a chemical active liquid during the pressure phase to aid in the generation of bubbles.

An exemplary system for treating a semi-conductor wafer for photo-resist removal in an enclosed solvent vacuum cycle nucleation processing system, includes two solvent supply systems in sealable communication with a processing chamber comprises the steps of:
(a) sealing the solvent supply systems with respect to the chamber;
(b) opening the chamber to atmosphere and placing a wafer to be treated on a rotational disk in the chamber;
(c) evacuating the chamber to remove air and other non-condensable gases;
(d) sealing the chamber with respect to atmosphere;
(e) opening the chamber with respect to the solvent supply system one and introducing a solvent into the evacuated chamber to submerge the wafer;
(f) processing the wafer by pulling vacuum in the chamber to produce vapor bubbles at the surface of the wafer;
(j) recovering the solvent introduced into the chamber and returning it to solvent supply system one;
(h) opening the chamber with respect to the solvent supply system two and introducing a solvent into the evacuated chamber to submerge the wafer;
(i) processing the wafer by pulling vacuum in the chamber to produce vapor bubbles at the surface of the wafer;
(j) recovering the solvent introduced into the chamber and returning it to solvent supply system two;
(k) recovering the residual solvent and vapor from the chamber by reducing the pressure and drying the wafer;
(l) opening the chamber with respect to atmosphere;
(m) opening the chamber and removing the treated wafer.

Alternatively, the CNP process can utilize alternating the different concentrations of multiple fluids mixtures/vapors to treat surfaces of an object. An example of the new CNP process would in the removal of complex molecular chain structured material such as a polymer and/or adhesive from an object: An enclosed solvent or aqueous chemical cycle nucleation (CNP) system includes a chamber for holding a wafer to be processed. At least one vacuum pump applies a negative gauge pressure to the chamber to remove air and other non-condensable gases. Means are provided for introducing a solvent mixture of .01% up to 30% of oxidizer such as hydrogen peroxide and NMP to the evacuated chamber covering surfaces of object. CNP fluids can be introduced in a jet/vapor or as a fluid. The solvent/oxidizer mixture of organic medium used to dissolve the complex chemical bonds of the long molecular chain contaminates such as find in polymer, adhesives and electronic fluxes and an inorganic solution such as a peroxide or acid used to oxidize the carbon element. A first system removes pressure from the chamber to produce vapor bubbles for agitation and disruption of the boundary layer surrounding the polymer and to vaporize the inorganic component for faster reaction in the vapor state. Upon recovering the solvent, a second solvent mixture is introduced to the chamber and a second system removes pressure from the chamber to produce vapor bubbles for agitation and rinsing of the object. The system includes recovery of the solvent from the chamber and object. This CNP enhancement is invented to target difficult to remove materials from surfaces by alternating concentration of solvent mixtures and with recovery of said mixtures.

An exemplary system for treating a object in an enclosed solvent vacuum cycle nucleation processing system, includes two or more solvent mixture supply systems in sealable communication with a processing chamber comprises the steps of:
(a) sealing the solvent supply systems with respect to the chamber;
(b) opening the chamber to atmosphere and placing an object to be treated on a rotational disk in the chamber;
(c) evacuating the chamber to remove air and other non-condensable gases;
(d) sealing the chamber with respect to atmosphere;
(e) opening the chamber with respect to the solvent mixture supply system one and introducing a solvent mixture into the evacuated chamber to cover surfaces of said object;
(f) processing the object by pulling vacuum in the chamber to produce vapor bubbles at the surface of the wafer;
(j) recovering the solvent introduced into the chamber and returning it to solvent supply system one;
(h) opening the chamber with respect to the solvent mixture supply system two and introducing a solvent mixture into the evacuated chamber to covering surfaces of said object;
(i) processing the object by pulling vacuum in the chamber to produce vapor bubbles at the surface of the wafer;
(j) recovering the solvent introduced into the chamber and returning it to solvent supply system two;
(k) recovering the residual solvent and vapor from the chamber by reducing the pressure and drying the wafer;
(l) opening the chamber with respect to atmosphere;
(m) opening the chamber and removing the treated wafer.

## Claims

1. A method for treating an object in a process chamber, comprising:
introducing a cleaning liquid to submerge at least a portion of the object (1050);
alternating pressure and vacuum within the process chamber to cause decompression bubbles to form and terminate at a submerged surface of the object (1052); and
**characterized by**
flowing a chemical active liquid or agent to aid in the generation of the bubbles at the object surface (1054).

2. A method as in claim 1, comprising only one of the following steps:
- removing the cleaning liquid from the surface of the object;
- replenishing the cleaning liquid after removing the cleaning liquid from the surface of the object;
- flushing the chemical active liquid from the cleaning liquid for aiding in removing bubbles;
- heating the object to aid in forming the bubbles at the submerged surface of the object;
- reducing heating to aid in terminating the bubbles.

3. A method according to one of the foregoing claims, **characterised in that** the chemical active liquid is either a peroxide or an acid.

## Patentansprüche

1. Verfahren zur Behandlung eines Gegenstandes in einer Behandlungskammer, umfassend:
Einleiten einer Reinigungsflüssigkeit zum Eintauchen mindestens eines Teils des Objekts (1050);
Abwechseln von Druck und Vakuum in der Behandlungskammer, um die Dekompressionsblasen zu erzeugen, die sich an einer eingetauchten Oberfläche des Objekts (1052) bilden und enden; und **gekennzeichnet durch**
Zuführen einer chemisch aktiven Flüssigkeit oder Mittels, um die Bildung der Blasen an der Objektoberfläche (1054) zu unterstützen.

2. Verfahren nach Anspruch 1, das nur einen der folgenden Schritte umfasst:
- Entfernen der Reinigungsflüssigkeit von der Oberfläche des Objekts;
- Wiederauffüllen der Reinigungsflüssigkeit nach dem Entfernen der Reinigungsflüssigkeit von der Oberfläche des Gegenstands;
- Spülen der chemisch aktiven Flüssigkeit aus der Reinigungsflüssigkeit, um das Entfernen von Blasen zu unterstützen;
- Erhitzen des Gegenstands, um die Bildung der Blasen an der eingetauchten Oberfläche des Gegenstands zu unterstützen;
- Reduzieren der Erwärmung, um die Blasenbildung zu unterstützen.

3. Verfahren nach einem der vorangehenden Ansprüche, **dadurch gekennzeichnet, dass** die chemisch aktive Flüssigkeit entweder ein Peroxyd oder eine Säure ist.

## Revendications

1. Procédé de traitement d'un objet dans une chambre de processus, comprenant :
l'introduction d'un liquide de nettoyage pour immerger au moins une partie de l'objet (1050) ;
l'alternance de pression et de vide à l'intérieur de la chambre de processus pour provoquer la formation de bulles de décompression et leur arrêt au niveau d'une surface immergée de l'objet (1052) ; et
**caractérisé par** l'écoulement d'un liquide ou d'un agent chimique actif pour aider à générer des bulles au niveau de la surface de l'objet (1054).

2. Procédé selon la revendication 1, comprenant uniquement l'une des étapes suivantes :
- l'élimination du liquide de nettoyage de la surface de l'objet ;
- la reconstitution du liquide de nettoyage après avoir éliminé le liquide de nettoyage de la surface de l'objet ;
- le rinçage du liquide chimique actif du liquide de nettoyage pour aider à éliminer les bulles ;
- le chauffage de l'objet pour aider à former les bulles au niveau de la surface immergée de l'objet ;
- la réduction du chauffage pour aider à arrêter les bulles.

3. Procédé selon l'une des revendications précédentes, **caractérisé en ce que** le liquide chimique actif est soit un peroxyde, soit un acide.
